(19) Europäisches Patentamt
European Patent Office
Office européen des brevets

(11) Publication number: **0 657 994 A1**

# (12) EUROPEAN PATENT APPLICATION

(21) Application number: **94119344.3**

(22) Date of filing: **07.12.94**

(51) Int. Cl.[6]: **H03B 5/36**, H03L 3/00, H03K 3/354

(30) Priority: **07.12.93 JP 306847/93**

(43) Date of publication of application: **14.06.95 Bulletin 95/24**

(84) Designated Contracting States: **DE FR GB**

(71) Applicant: **NEC CORPORATION**
**7-1, Shiba 5-chome**
**Minato-ku**
**Tokyo (JP)**

(72) Inventor: **Tsuboi, Toshihide, c/o NEC Corporation**
**7-1, Shiba 5-chome,**
**Minato-ku**
**Tokyo (JP)**

(74) Representative: **Betten & Resch**
**Reichenbachstrasse 19**
**D-80469 München (DE)**

## (54) Oscillation circuit oscillating even on low power voltage.

(57) The oscillator circuit of the present invention includes a first MOSFET of a first conductivity type having its source and gate connected to a first power supply and to an input terminal, respectively, a second MOSFET of a second conductivity type having its source and gate connected to a second power supply and to the input terminal, respectively, and having its drain connected in common with the drain of the first MOSFET to an output terminal, a resistor connected across the first power supply and the drain of the first MOSFET, a resistor and a quartz oscillator connected in parallel with each other across the input terminal and the output terminal, and capacitors connected across both terminals of the quartz oscillator and the ground.

Fig. 1

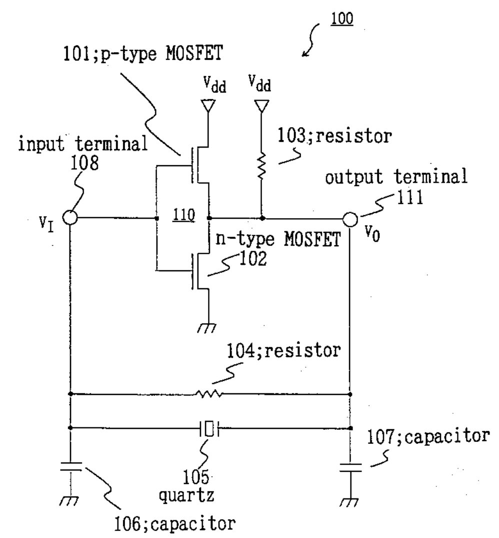




Rank Xerox (UK) Business Services
(3.10/3.09/3.3.4)

BACKGROUND OF THE INVENTION

Field of the Invention

This invention relates to an oscillation circuit and, more particularly, to an oscillation circuit that may be set into oscillation at a low voltage.

Related Art

Heretofore, an oscillator employing a quartz oscillator in a semiconductor integrated circuit of the CMOS structure is arranged as shown in Fig.4.

In the prior-art example, shown in Fig.4, a p-type(p-channel) MOSFET 501 and an n-type(n-channel) MOSFET 502, connected in a form of a complementary pair, constitutes an inverter. A resistor 504 and a quartz oscillator 505 are connected in parallel to each other across the input and the output of the inverter, and capacitors 506, 507 are provided across both terminals of the quartz oscillator 505 and the ground.

Although the resistor 504 and the capacitors 506, 507 are occasionally formed on a semiconductor integrated circuit, they are shown herein as being provided externally of the semiconductor integrated circuit, because such is not essential to the description of the present invention.

In the present prior-art example, the inverter formed on the semiconductor integrated circuit operates as an amplifier, while the capacitors 506, 507 and the quartz oscillator 505 operate as a frequency filter, so that the components shown operate as an oscillator in their entirety.

It is first assumed that a power supply voltage (referred to hereinafter as Vdd) is no less than the sum of a threshold voltage at which the n-type MOSFET 502 begins to be conductive(referred to hereinafter as VTN) and a threshold voltage at which the p-type MOSFET 502 begins to be conductive(referred to hereinafter as VTP). That is, the power supply voltage Vdd is assumed to be in a range that can be expressed as,

$$VTN + |VTP| \leqq Vdd \qquad (1)$$

where a symbol "| VTP |" denotes the absolute value of VTP. The reason is that the threshold voltage of a MOSFET is associated with the gate-to-source voltage at which the MOSFET begins to turn on such that the threshold voltage VTP of the p-type (enhancement) MOSFET is dealt with as a negative value, while the threshold voltage VTN of the n-type (enhancement) MOSFET is of a positive value .

If the input voltage applied to an input terminal 508 of the inverter is in a range from 0 to VTN, the p-type MOSFET 501 is in a conductive state, while the n-type MOSFET 502 is in a non-conductive state, so that a Vdd level is outputted at an output terminal 511 of the inverter.

If the inverter input voltage is in a range from Vdd - | VTP | to Vdd, the p-type MOSFET 501 is in a non-conductive state and the n-type MOSFET 502 is in a conductive state, so that a zero level is outputted at the output terminal 511 of the inverter.

If the input voltage to the inverter is in a range from VTN to Vdd - | VTP |, both the p-type MOSFET 501 and the n-type MOSFET 502 are in the conductive state and exhibit characteristics in which, the higher the input voltage, the lower becomes the output voltage, as shown in Fig.5. Above all, these MOSFETs operate as an inverting amplifier having a certain gain in the region wherein the input voltage and the output voltage are approximately equal to each other.

If, in the present example, the voltage Vdd is applied, the inverter input is biased by the resistor 504 so that the inverter input voltage becomes equal to the inverter output voltage. After lapse of several msec to several sec in this state, minute oscillations present at the inverter input are amplified, resulting in a growth of the oscillations to produce an oscillation output.

It is now assumed that the power supply voltage Vdd is lower than the sum of threshold voltage levels VTN and VTP, that is, the condition is given as a following expression.

$$VTN + |VTP| > Vdd \qquad (2)$$

Fig.6 shows a graph of input/output characteristics of the inverter made up of complementary MOSFETs for the lower power supply voltage Vdd as defined in the above expression (2), wherein the threshold voltage of n-type MOSFET VTN is larger than Vdd - | VTP |.

If, as shown in Fig.6, the input voltage to the inverter is in a range from 0 to Vdd - | VTP |, the p-type MOSFET 501 is in a conducting state, while the n-type MOSFET 502 is in a non-conducting state, so that the inverter outputs the Vdd level.

If the input voltage to the inverter is in a range from VTN to Vdd, the p-type MOSFET 501 is in a non-conducting state, while the n-type MOSFET 502 is in a conducting state, so that the inverter outputs the zero level.

If the input voltage to the inverter is in a range from Vdd - | VTP | to VTN, both the p-type MOSFET 501 and the n-type MOSFET 502 are in the non-conducting state, with the inverter output being is a high-impedance state.

As described above, if the power supply voltage Vdd is set lower than the sum of the threshold voltage levels of VTN and VTP, there is no input voltage range in the inverter capable of amplifying the minute oscillations. Thus there occurs no growth of the oscillations in the present example, such that no oscillation output signal can be produced.

In such oscillator, the technique of reducing at least one of VTN and VTP of the MOSFETs making up the oscillator has hitherto been employed for lowering the minimum oscillation voltage.

The minimum oscillation voltage may indeed be lowered in this manner. However, the current flowing through such oscillator depends on VTN and VTP, as shown in Fig.7. In addition, such inconvenience arises that, if the power supply voltage is raised, the power supply current is increased.

In addition, with such technique, if VTN and VTP of the semiconductor integrated circuit in its entirety are lowered, data retention characteristics are disadvantageously deteriorated, while the current flowing through the circuit in its entirety is also disadvantageously increased. Thus it has generally been practiced to lower the VTN and VTP for the MOSFETs constituting the oscillator only. However, in such case, the production process tends to be complex, thus entailing disadvantages in the term of production and production cost.

The JP Patent Publication No. Hei 2-222307 (1990) discloses a technique of changing over the MOSFETs operating as an oscillator amplifier between the high power supply voltage and the low power supply voltage for reducing the power supply current during the time of a high power supply voltage. However, with this technique, not only the circuit becomes complex, but also the minimum oscillation voltage essentially depends on VTN and VTP, so that, for producing a low oscillation voltage, it becomes necessary to lower one threshold voltage of VTN and VTP of the MOSFETs constituting the above-mentioned oscillator.

Further, with this technique, the threshold voltage of the inverter operating as the oscillator amplifier may be changed slightly, at the time of changing over MOSFETs, as a result of which there may be generated a noise to be included in the oscillation output signal.

As described above, the conventional semiconductor integrated circuit suffers from the drawback that, if Vdd is lower than the sum of the voltage levels VTN and VTP, the oscillation output cannot be produced using a quartz oscillator.

For producing the oscillation output, it becomes necessary to lower one of VTN and VTP of the MOSFETs. However, in such case, not only the source current is increased, but also the production process becomes complex, thus entailing prolonged term of production and increased production cost.

## SUMMARY OF THE INVENTION

In view of the above-mentioned drawbacks of the prior art circuit, it is an object of the present invention to provide an oscillation circuit which oscillates even though a source voltage is low.

An oscillator circuit according to the present invention is characterized by connecting a resistive element between an output of an inverter and a power supply terminal.

With the circuit feature as described above, even if the power supply voltage is lower than the sum of the threshold voltages of transistors constituting the inverter to thereby make an input voltage to the input of the inverter have such a value that renders the transistors non-conductive, the output of the inverter is pulled up to the level of the source voltage by the resistive element, so that there is no risk of the inverter output being in a high-impedance state.

It is preferable to set the input voltage applied to the inverter and the output voltage of the inverter so as to be in a pre-set range from the power supply voltage Vdd to zero (GND level), the inverter cooperates with the resistive element to serve an inverting amplifier having a certain gain. By employing such input bias, the inverter may perpetually be set into oscillation without regard to the power supply voltage or to the MOSFET threshold voltage.

## BRIEF DESCRIPTION OF THE DRAWINGS

The above and other objects, features and advantages of the present invention will be more apparent from the following description taken in conjunction with the accompanying drawings, in which

Fig.1 is a circuit diagram showing a first embodiment of the present invention;

Fig.2 is a graph showing input/output characteristics of an inverter according to a first embodiment;

Fig.3 is a circuit diagram showing a second embodiment of the present invention;

Fig.4 is a circuit diagram showing a prior-art example of an inverter; Fig.5 is a graph showing input/output characteristics for the prior-art example inverter for the higher power supply voltage;

Fig.6 is a graph showing input/output characteristics for the prior-art example inverter for the lower power supply voltage; and

Fig.7 is a graph showing a typical current flowing through an oscillator.

## DESCRIPTION OF THE PREFERRED EMBODIMENTS

Referring now to Fig.1, an oscillation circuit 100 according to the first embodiment of the present invention includes an inverter 110 made up of a p-type or p-channel insulated-gate field effect transistor (called hereinafter MOSFET) 101 and an n-type or n-channel MOSFET 102 connected in series between a power terminal Vdd and a ground terminal. A resistor 104 and a resonant element 105 such as quartz are connected in parallel between the input and the output of the inverter 110, and capacitors 106 and 107 are connected between both terminals of the quartz oscillator 105 and the ground, respectively. The input of the inverter 110 is connected to an input terminal 108, and the output thereof is connected to an output terminal 111.

The present oscillation circuit 110 further includes a resistor 103 in accordance with the present invention. This resistor 103 is connected between the power supply Vdd and the drain of the p-type MOSFET 101 operates as an amplifier, while the capacitors 106, 107 and the quartz oscillator 105 operate as a frequency filter, such that the circuit 100 in its entirety operates as an oscillator.

The inverter 110 and the resistor 103 are fabricated on a single semiconductor chip. Although the resistor 104 and the capacitors 106 and 107 are shown as being provided outside of the semiconductor integrated circuit, they may be also fabricated on the semiconductor chip.

When the power supply voltage Vdd is higher than the sum of the threshold voltages VTN and | VTP | of the MOSFETs 102 and 101, the operation of the oscillation circuit 100 becomes similar to the operation of the prior-art circuit shown in Fig. 4, so that the corresponding description is not repeated.

When the power supply voltage Vdd is lowered to such a level that is lower than the sum of the VTN and VTP voltage levels, that is, VTN + | VTP | < Vdd, the input-output voltage characteristic as shown in Fig. 2 is derived.

More specifically, if the input voltage $V_I$ applied to the input terminal 108 is in a range from 0 to Vdd - | VTP |, the p-type MOSFET 101 is in a conducting state, while the n-type MOSFET 102 is in a non-conducting state, so that the Vdd level is outputted as the output voltage $V_O$ at the output terminal 111, as shown in Fig. 2.

If the input voltage $V_I$ is in a range from VTN to Vdd, the p-type MOSFET 101 is in a non-conducting state, while the n-type MOSFET 102 is in the conducting state, so that the output voltage $V_O$ takes a zero level, as shown in Fig. 2.

If the inverter input voltage $V_I$ is in a range from Vdd - | VTP | to VTN, both the p-type MOSFET 101 and the n-type MOSFET 102 are in the non-conducting state. The voltage level $V_O$ at the output terminal 111 is thereby pulled up to the Vdd level by the resistor 103, as shown in Fig. 2. Consequently, with the present embodiment, the circuit made up of the p-type MOSFET 101, the n-type MOSFET 102 and the resistor 103 operate as an inverting amplifier having a certain gain within a range of the input voltage approximately being equal to VTN.

As shown therein, by setting the inverter input voltage so as to be substantially equal to VTN, the circuit made up of the p-type MOSFET 101, n-type MOSFET 102 and the resistor 103 is biased so as to have an amplification factor, so that minute oscillations present in the inverter input are amplified and grown in amplitude to produce an oscillation output.

A comparative experiment was conducted on the above-described oscillation circuit 100 of the present embodiment and the conventional oscillation circuit shown in Fig.5. The results are shown in Table 1.

In the present experiment, comparison was made of the minimum Vdd values for which oscillation outputs could be produced.

The device dimension parameters of MOSFETs and element values are as follows.
channel width of the p-type MOSFETs 101,501••• 16μm
channel length of the p-type MOSFETs 101,501••• 12μm
channel width of the n-type MOSFETs 102,502••• 8μm
channel length of the n-type MOSFETs 102,502••• 12μm
gate oxide film thickness of MOSFETs 101,102,501, 502••• 280μm
resistance value of resistor 103••• 50KΩ
resistance values of resistors 104,504••• 5MΩ
capacitance values of capacitors 106,107,506,507••• 15pF

Table 1

| Threshold voltage level | Oscillation start voltage with the conventional circuit | Oscillation start voltage by the present invention |
|---|---|---|
| Vt level 1 | 1.26 V | 1.26 V |
| Vt level 2 | 1.54 V | 1.40 V |
| Vt level 3 | 1.68 V | 1.23 V |
| Vt level 4 | 1.75 V | 1.40 V |
| Vt level 5 | 2.02 V | 1.42 V |

In above Table 1, Vt levels 1 to 4 indicate the ranks of MOSFET threshold voltage levels VTN and VTP in an ascending order. For example, Vt level 1 denotes a group of MOSFETs that are manufactured to have lowest threshold voltage values of both VTN and VTP, while Vt level 5 denotes a group of MOSFETs having highest threshold voltage values of both VTN and VTP. The oscillation start voltage indicates the minimum value of the power supply voltage Vdd at which the oscillation can be started.

The results in Table 1 clearly demonstrate the effects in lowering the power supply voltage with which the oscillation is achievable, by the present embodiment.

In addition, since no means of lowering VTN and VTP is employed in the present embodiment for lowering the power supply voltage enabling the oscillator to be set in oscillation, there is no risk of the circuitry other than the oscillator being lowered in characteristics or of the production cost being raised.

Turning to Fig.3, an oscillation circuit 400 according to a second embodiment of the present invention includes, in place of the resistor 103 of the embodiment 1 shown in Fig.1, an n-type normally-on MOSFET 403. The arrangement of a p-type MOSFET 401, an n-type MOSFET 402, a resistor 404, a quartz oscillator 405, capacitors 406, 407, an input terminal 408 and an output terminal 409 are similar to that of the p-type MOSFET 101, n-type MOSFET 102, resistor 104, quartz oscillator 105, capacitors 106, 107, input terminal 108 and the output terminal 109, shown in Fig.1, so that the corresponding description is not made.

The n-type normally-on MOSFET 403 has its drain connected to a power supply Vdd, while having its source connected to the output terminal and having its gate grounded.

With the present embodiment, since the gate-to-drain voltage of the n-type normally-on MOSFET 403 is negative and the absolute value thereof is increased with rise in Vdd, the on-resistance is increased. Thus the present embodiment has the effect that, as compared to the first embodiment, the current flowing through the oscillator becomes smaller for a larger value of Vdd.

The above described preferred embodiments are illustrative and not restrictive. For example, a depletion type MOSFET may be employed in place of the resistor 103 and the MOSFET 403. Further, the feedback resistor 104 or 404 can be replaced with a pair of n-channel and p-channel MOSFETs whose gates are connected to the ground and the power supply terminal, respectively.

## Claims

1. An oscillator circuit comprising an inverter, a resonant circuit connected between an input and an output of said inverter, and a resistive element connected between an power supply terminal and the output of said inverter.

2. The oscillator circuit as defined in claim 1, wherein said inverter is formed of a CMOS inverter.

**3.** The oscillator circuit as defined in claim 1, wherein said resonant circuit comprises at least a resonant element and a feedback circuit connected in paralle.

**4.** An oscillator circuit comprising:

a first transistor of a first conductivity type having a source and a gate connected to a first power supply terminal and an input terminal, respectively;

a second transistor of a second conductivity type having a source and a gate connected to a second power supply and the input terminal, respectively, and having a drain connected in common with a drain of the first transistor to an output terminal;

a resistive element connected between the first power supply and the output terminal; and

a feedback circuit and a quartz oscillator connected in parallel with each other between the input terminal and the output terminal.

**5.** The oscillator circuit as defined in claim 4, wherein said resistive element comprises a resistor.

**6.** The oscillator circuit as defined in claim 4, wherein said resistive element comprises a field effect transistor.

Fig. 1

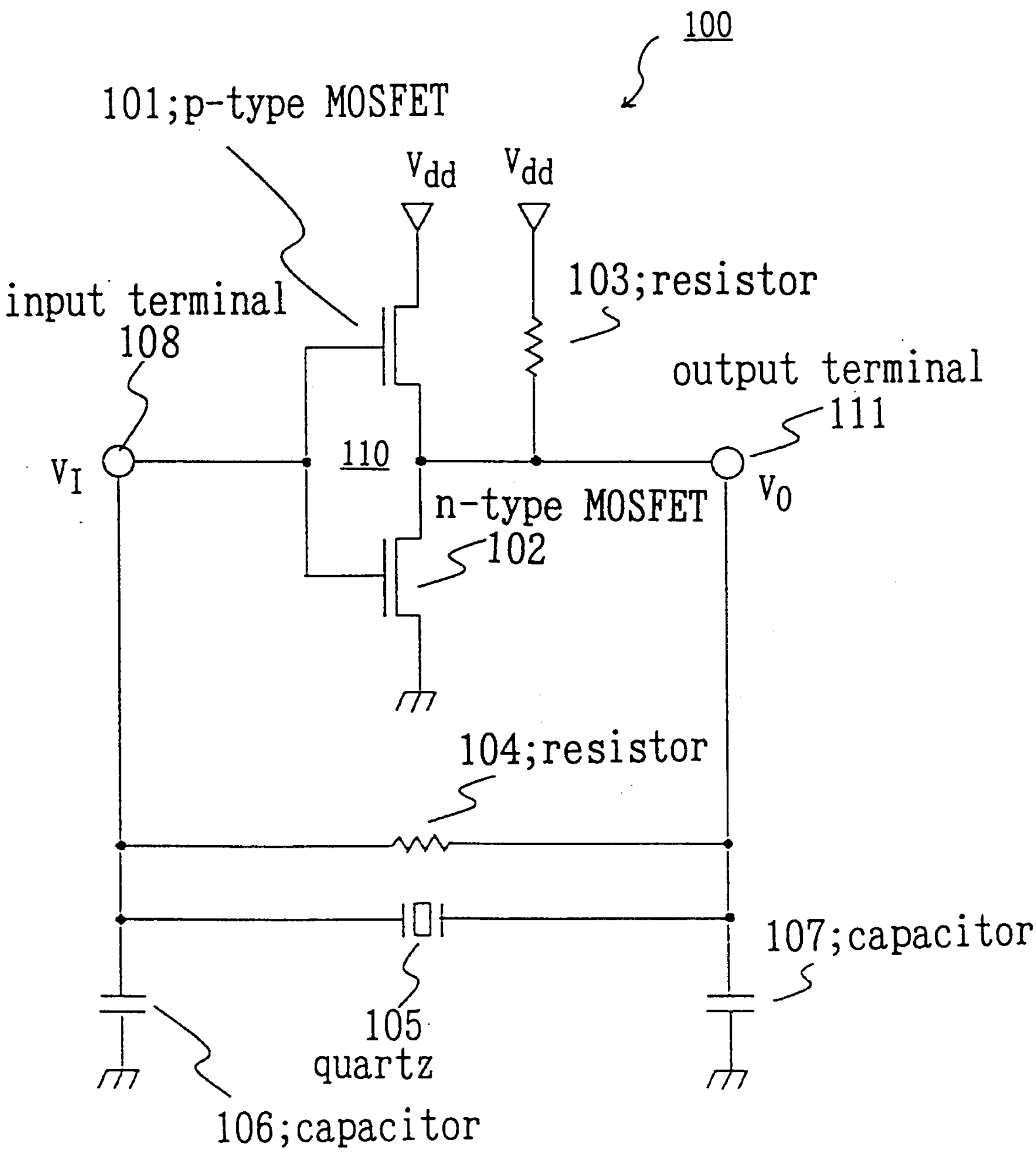
100
101;p-type MOSFET
$V_{dd}$
$V_{dd}$
103;resistor
input terminal
108
output terminal
111
$V_I$
110
$V_O$
n-type MOSFET
102
104;resistor
107;capacitor
105
quartz
106;capacitor

Fig. 2

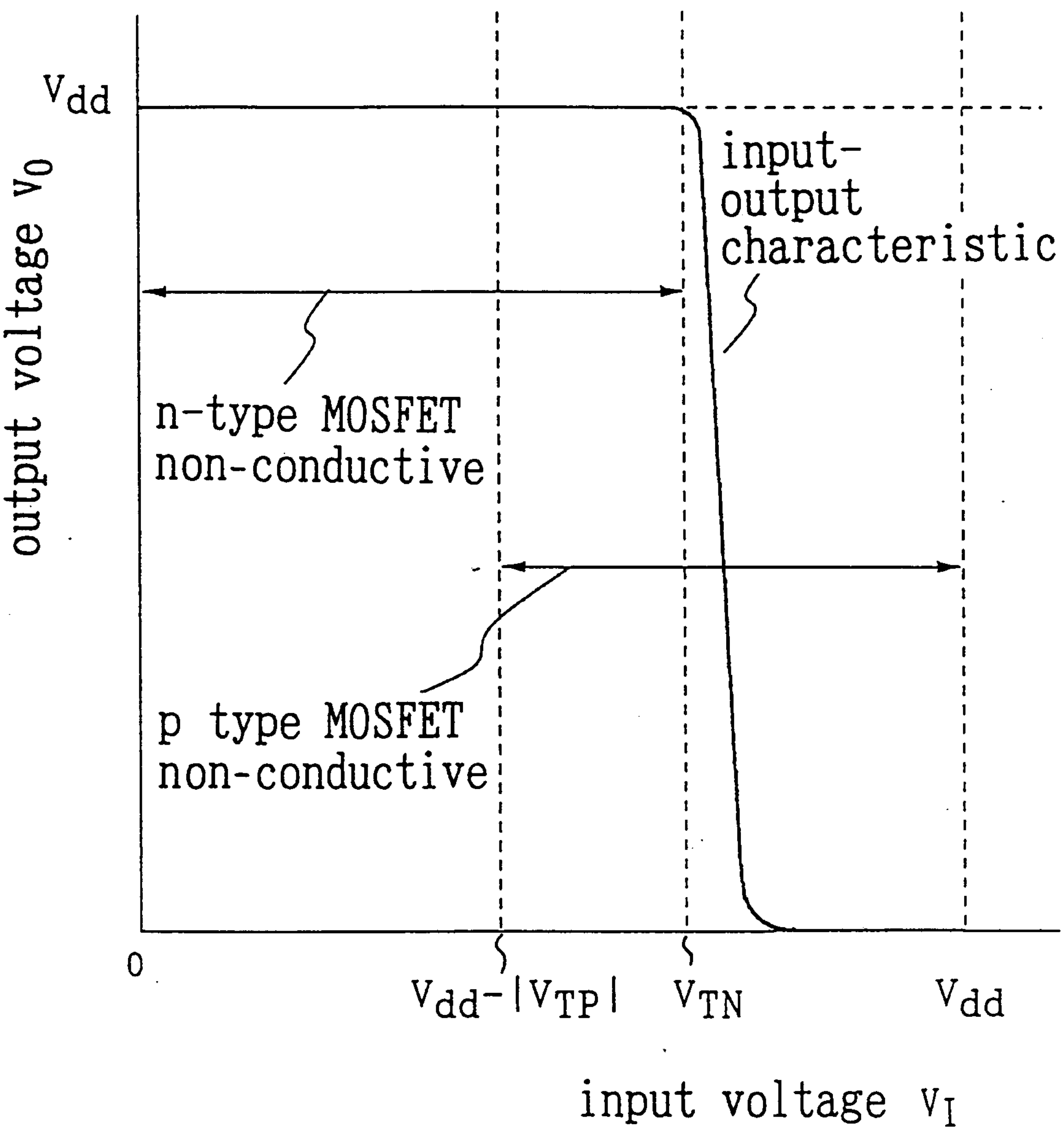
Vdd
output voltage V0
input-
output
characteristic
n-type MOSFET
non-conductive
p type MOSFET
non-conductive
0
Vdd-|VTP|
VTN
Vdd
input voltage VI

Fig. 3

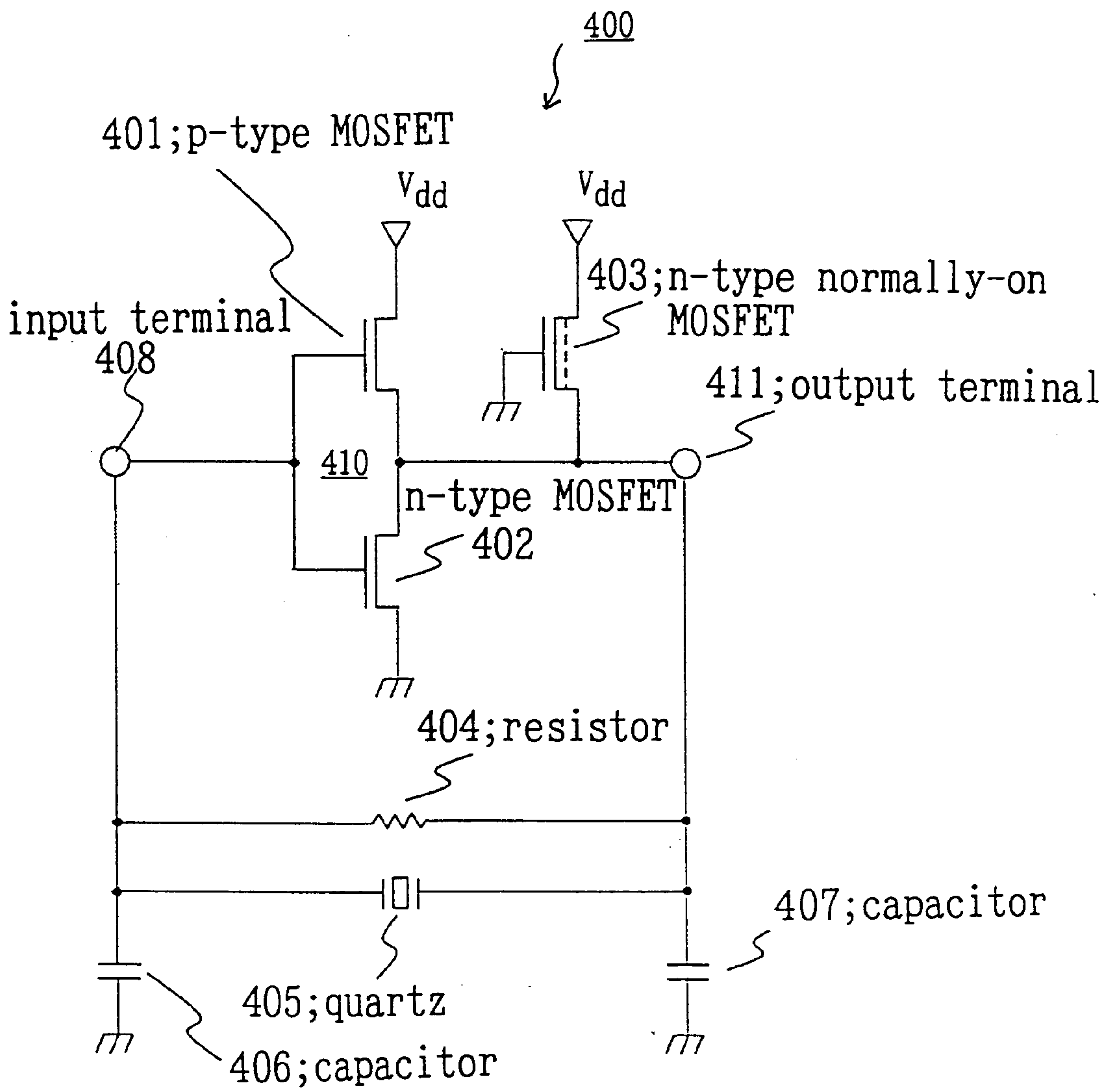
400
401;p-type MOSFET
$V_{dd}$
$V_{dd}$
403;n-type normally-on MOSFET
input terminal 408
411;output terminal
410
n-type MOSFET 402
404;resistor
407;capacitor
405;quartz
406;capacitor

Fig. 4 PRIOR ART

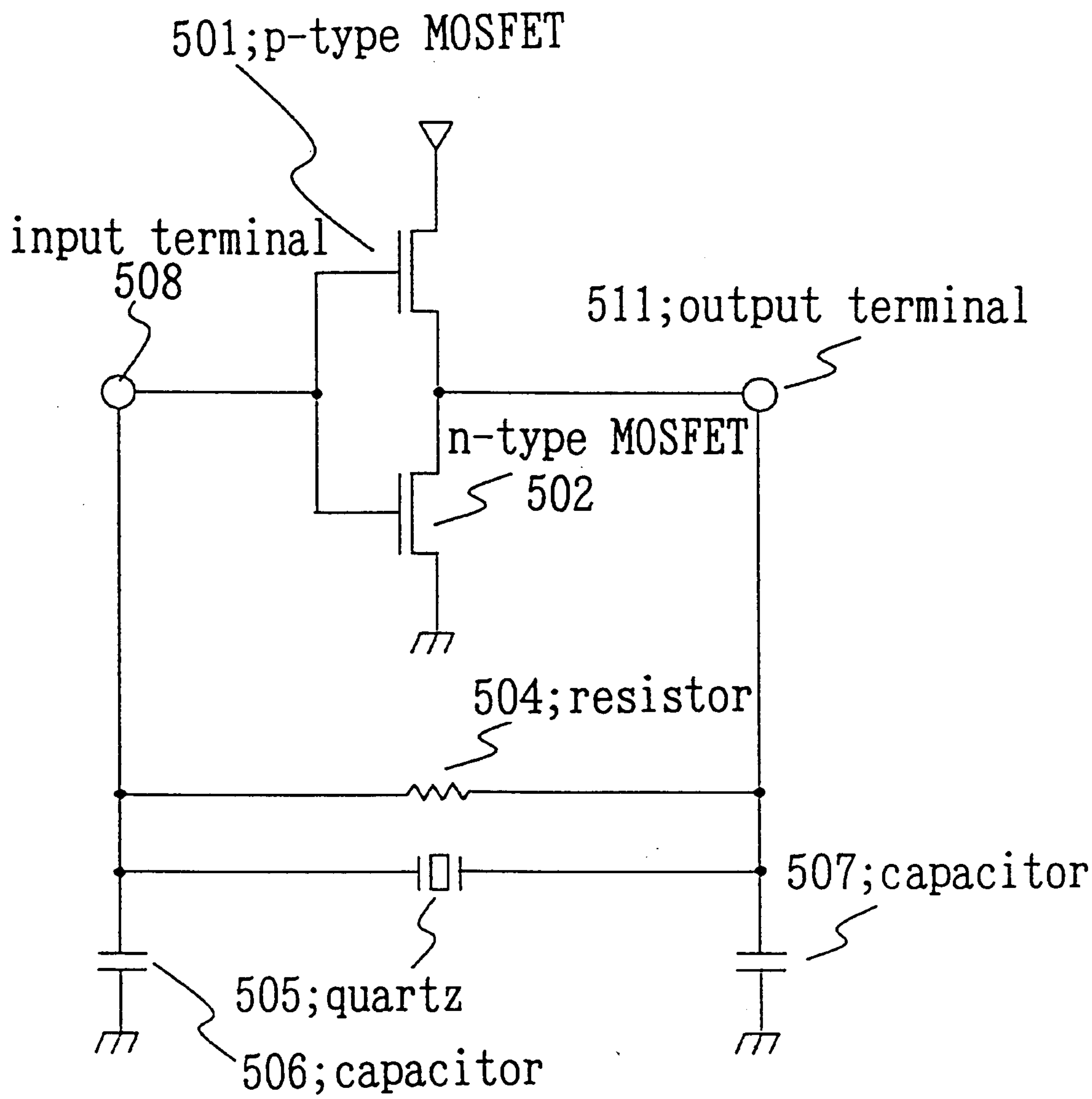

Fig. 5 PRIOR ART

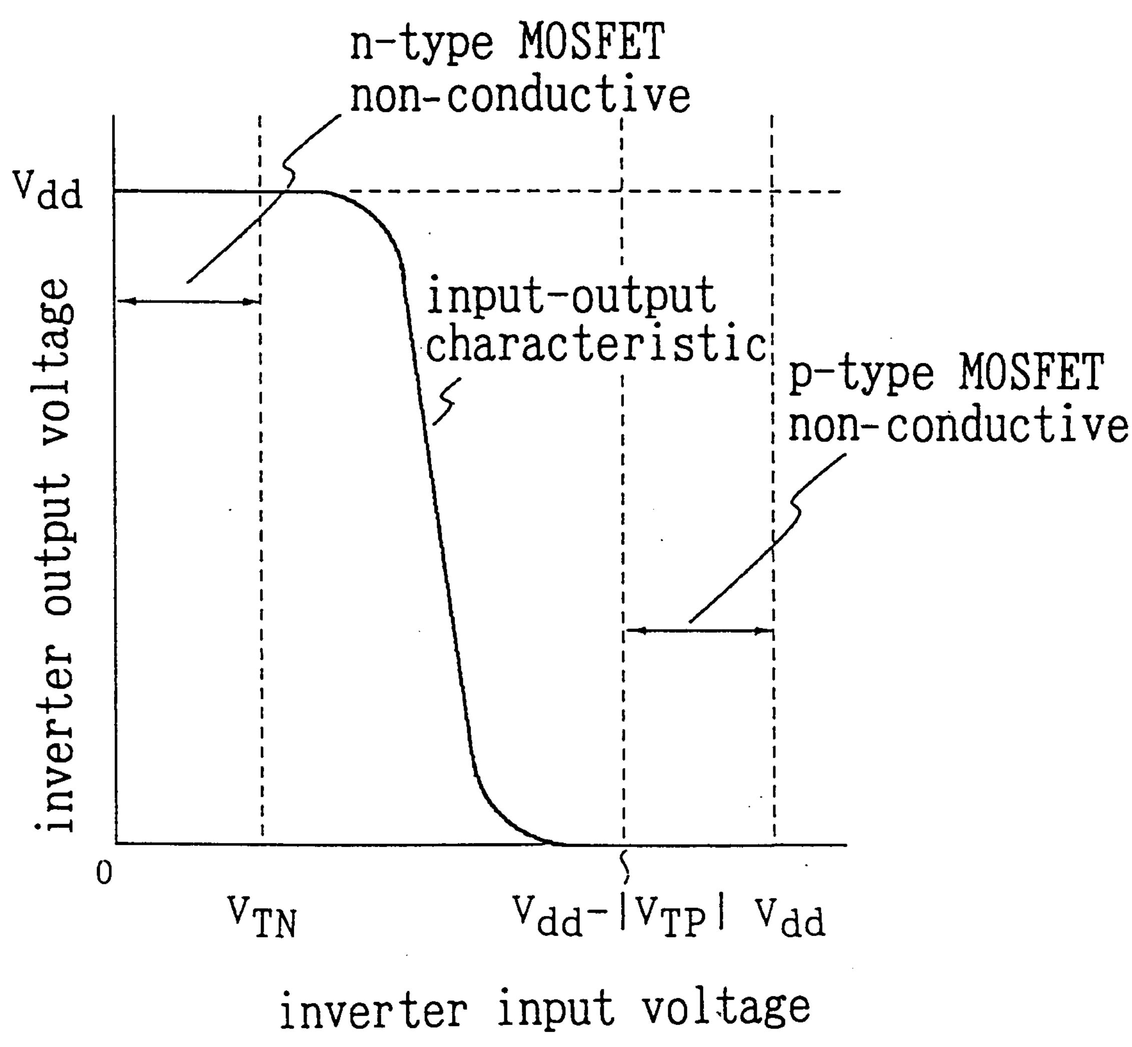

Fig. 6 PRIOR ART

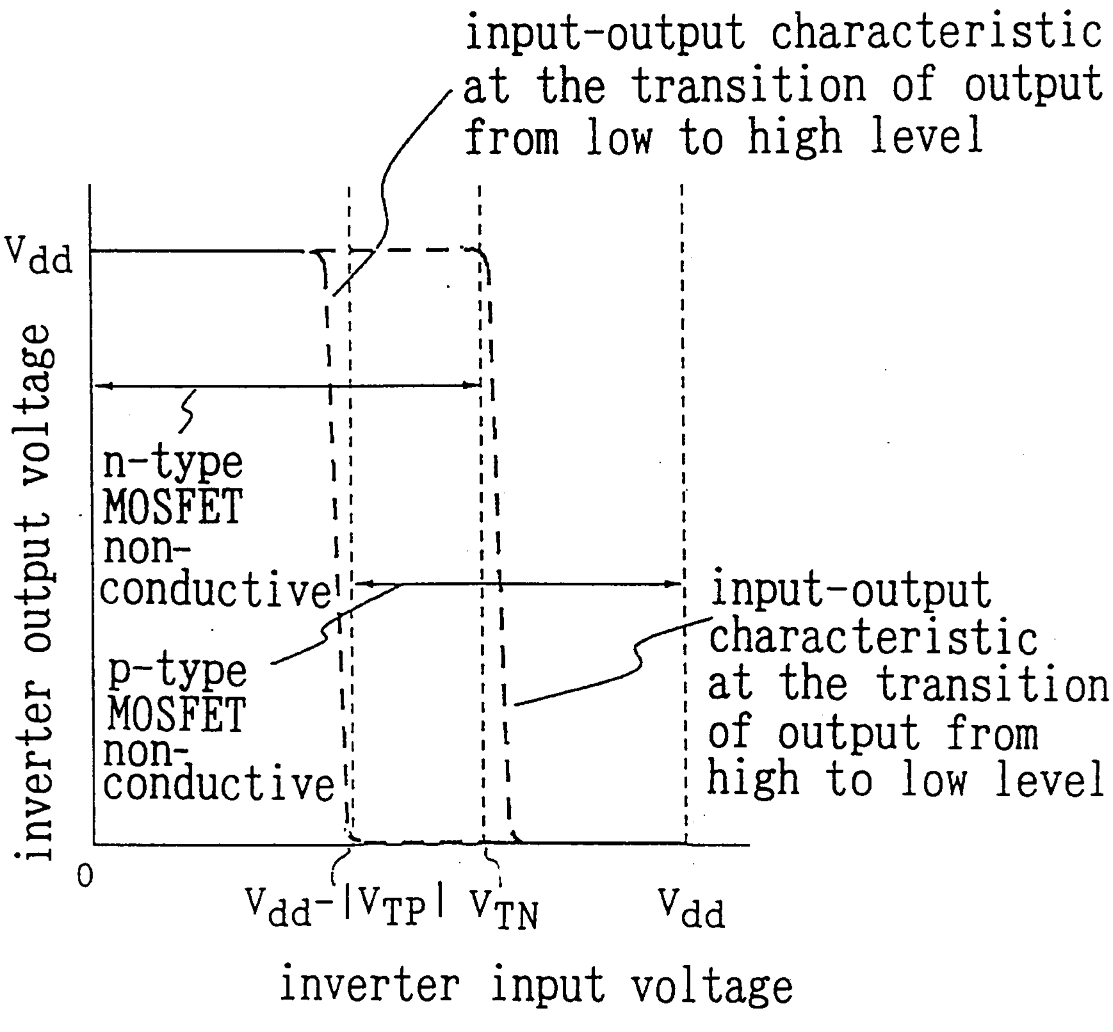

Fig. 7

PRIOR ART

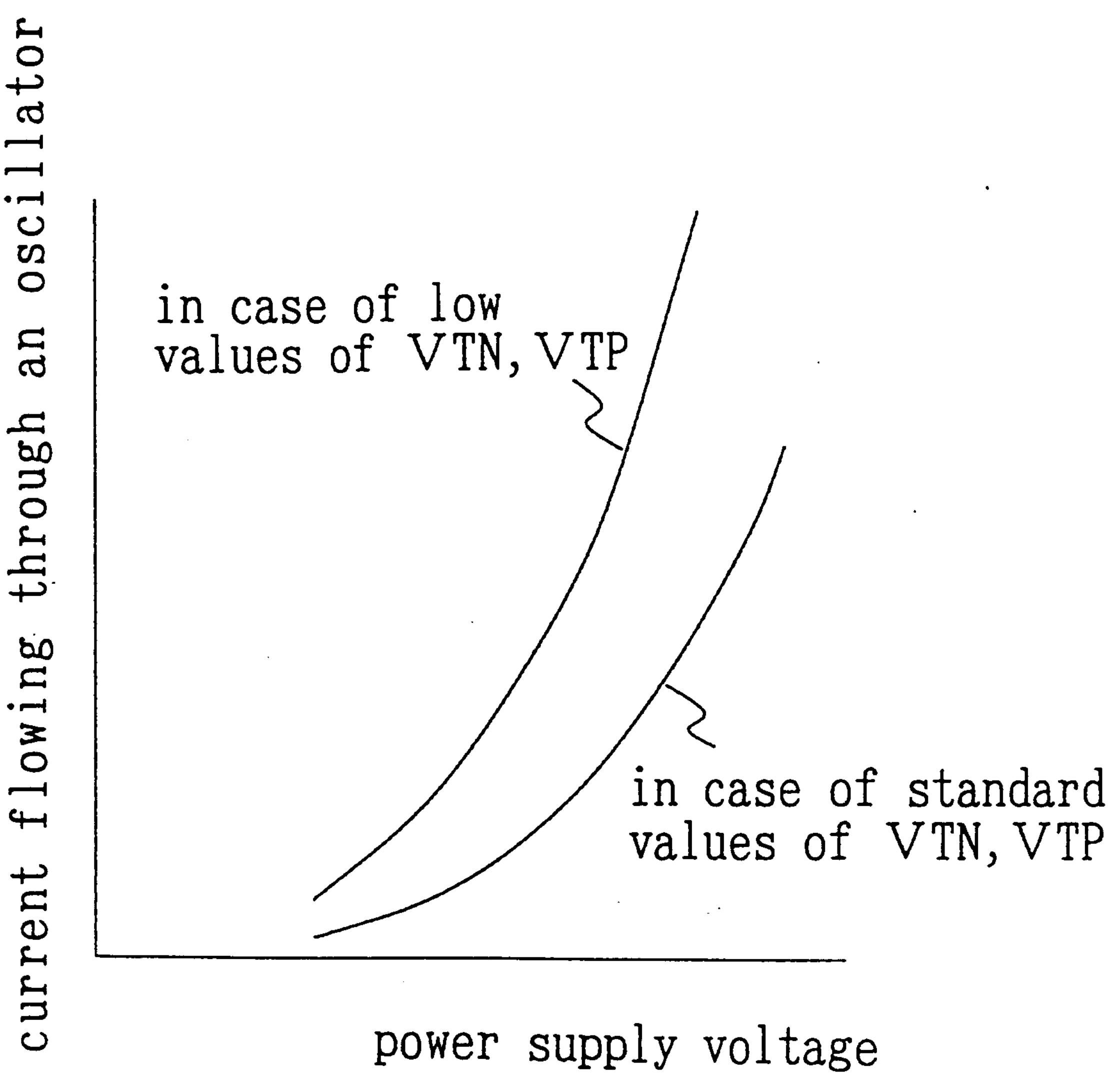

European Patent Office

# EUROPEAN SEARCH REPORT

Application Number
EP 94 11 9344

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-3 979 698 (W. GOLLINGER)<br>* the whole document *<br>--- | 1-6 | H03B5/36<br>H03L3/00<br>H03K3/354 |
| X | PATENT ABSTRACTS OF JAPAN<br>vol. 16, no. 550 (E-1292) 19 November 1992<br>& JP-A-04 208 701 (TOYO COMMUN EQUIP CO LTD)<br>* abstract *<br>--- | 1 | |
| A | US-A-3 889 211 (S. MOROZUMI)<br>* figure 4 *<br>----- | 6 | |
| | | | **TECHNICAL FIELDS SEARCHED (Int.Cl.6)** |
| | | | H03B<br>H03L<br>H03K |

The present search report has been drawn up for all claims

| Place of search | Date of completion of the search | Examiner |
|---|---|---|
| THE HAGUE | 23 February 1995 | Dhondt, I |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document